# EUROPEAN PATENT APPLICATION

(11) **EP 4 131 396 A1**
(43) Date of publication of application: **08.02.2023**
(21) Application number: 20900759.0
(22) Date of filing: 27.03.2020
(51) Int. Cl.: H01L 27/32, H01L 51/52

(54) **DISPLAY PANEL, METHOD FOR MANUFACTURING SAME AND ELECTRONIC DEVICE**

(71) Applicant: BOE Technology Group Co., Ltd., Beijing 100015 (CN)
(72) Inventor: HUANG, Kuanta, Beijing 100176 (CN); DONG, Yongfa, Beijing 100176 (CN); WANG, Qing, Beijing 100176 (CN); LI, Shipeng, Beijing 100176 (CN); WANG, Yu, Beijing 100176 (CN); TONG, Hui, Beijing 100176 (CN); YUAN, Xiong, Beijing 100176 (CN); SHEN, Xiaobin, Beijing 100176 (CN)
(74) Representative: Durán-Corretjer, S.L.P.
(86) International application number: PCT/CN2020/081837
(87) International publication number: WO 2021/189473

(57) **Abstract**

A display panel and a manufacturing method thereof, and an electronic device are provided. The display panel includes a substrate, an array structure layer and a light-emitting structure layer disposed on the substrate. The substrate includes a transistor, the array structure layer includes a first conductive post, a connecting electrode and a second conductive post, the light-emitting structure layer includes a first electrode, an organic light-emitting layer and a second electrode, the first electrode is located on one side of the organic light-emitting layer close to the substrate, and the second electrode is located on one side of the organic light-emitting layer away from the substrate. The first electrode includes a first sub-electrode, a second sub-electrode and a third sub-electrode, the second sub-electrode is located on one side of the first sub-electrode away from the substrate, and the third sub-electrode is located on one side of the first sub-electrode close to the substrate. Reflectivity of the first sub-electrode is greater than threshold reflectivity and greater than reflectivity of the second sub-electrode, and the reflectivity of the second sub-electrode is less than reflectivity of the third sub-electrode. The first electrode is connected with the connecting electrode through the second conductive post, and the connecting electrode is connected with a drain electrode of the transistor through the first conductive post.

## Description

### Technical Field

The present disclosure relates to, but is not limited to the technical field of display, in particular to a display panel and a manufacturing method thereof, and an electronic device.

### Background

Micro Organic Light-Emitting Diode (Micro-OLED) is a micro display developed in recent years, and silicon-based OLED is one thereof. The silicon-based OLED may not only realize active addressing of pixels, but also realize preparing a variety of functional circuits including timing control (TCON) circuit, over-current protection (OCP) circuit, or the like, on a silicon-based substrate, which is conducive to reducing system size and realizing light weight. The silicon-based OLED is prepared by a mature Complementary Metal Oxide Semiconductor (CMOS) integrated circuit process, has advantages of small size, high Pixels Per Inch (PPI), high refresh rate, etc., and is widely used in the near-eye display field of Virtual Reality (VR) or Augmented Reality (AR).

### Summary

The following is a summary of the subject matter described in detail in the present disclosure. This summary is not intended to limit the protection scope of the claims.

In a first aspect, the present disclosure provides a display panel, including a substrate and an array structure layer and a light-emitting structure layer which are sequentially disposed on the substrate, wherein the substrate includes a transistor, the array structure layer includes a first conductive post, a connecting electrode and a second conductive post which are sequentially disposed, the light-emitting structure layer includes a first electrode, an organic light-emitting layer and a second electrode, the first electrode is located on one side of the organic light-emitting layer close to the substrate, and the second electrode is located on one side of the organic light-emitting layer away from the substrate; the first electrode includes a first sub-electrode, a second sub-electrode and a third sub-electrode, wherein the second sub-electrode is located on one side of the first sub-electrode away from the substrate, and the third sub-electrode is located on one side of the first sub-electrode close to the substrate; reflectivity of the first sub-electrode is greater than threshold reflectivity and greater than reflectivity of the second sub-electrode, wherein the reflectivity of the second sub-electrode is less than reflectivity of the third sub-electrode; the first electrode is connected with the connecting electrode through the second conductive post, and the connecting electrode is connected with a drain electrode of the transistor through the first conductive post.

In some possible implementations, the second sub-electrode is a transmissive electrode, and an orthographic projection on the substrate covers an orthographic projection of the first sub-electrode on the substrate; an orthographic projection of the third sub-electrode on the substrate at least covers the orthographic projection of the first sub-electrode on the substrate, and the orthographic projection of the second sub-electrode on the substrate covers the orthographic projection of the third sub-electrode on the substrate.

In some possible implementations, the display panel further includes a gate line, a length of the first sub-electrode along a first direction is greater than a length of the second sub-electrode along the first direction, and a length of the first sub-electrode along a second direction is smaller than a length of the second sub-electrode along the second direction; the length of the second sub-electrode along the second direction is 1.2 times that of the first sub-electrode along the second direction; the first direction is perpendicular to the substrate, and the second direction is an extending direction of the gate line.

In some possible implementations, a manufacturing material of the first sub-electrode includes silver; the length of the first sub-electrode along the first direction is 400 angstroms to 600 angstroms, and the length of the first sub-electrode along the second direction is 1.5 microns to 2.5 microns.

In some possible implementations, a manufacturing material of the second sub-electrode includes indium tin oxide; the length of the second sub-electrode along the first direction is 120 angstroms to 180 angstroms, and the length of the second sub-electrode along the second direction is 1.8 microns to 4 microns.

In some possible implementations, a manufacturing material of the third sub-electrode includes titanium; a length of the third sub-electrode along the first direction is 80 angstroms to 120 angstroms, and a length of the third sub-electrode along the second direction is 1.5 microns to 2.5 microns.

In some possible implementations, a manufacturing material of the first sub-electrode includes silver, a manufacturing material of the second sub-electrode includes indium tin oxide, and a manufacturing material of the third sub-electrode includes titanium.

In some possible implementations, the threshold reflectivity is 80%; a work function of the second sub-electrode is greater than 5, and a light transmittance of the second sub-electrode is greater than 99%.

In some possible implementations, the display panel further includes a pixel definition layer, an encapsulating layer and a color filter layer; the pixel definition layer is located on one side of the array structure layer away from the substrate; the encapsulating layer is located on one side of the light-emitting structure layer away from the substrate; the color filter layer is located on one side of the encapsulating layer away from the substrate; wherein, the manufacturing material of the pixel definition layer includes silicon oxide.

In some possible implementations, the encapsulating layer includes a first inorganic encapsulating layer, a second inorganic encapsulating layer and a third organic encapsulating layer; the first inorganic encapsulating layer is located on one side of the second inorganic encapsulating layer close to the substrate; the third organic encapsulating layer is located on one side of the second inorganic encapsulating layer away from the substrate.

In some possible implementations, the display panel further includes a cover panel; the cover panel is located on one side of the color filter layer away from the substrate and is used for protecting the color filter layer.

In a second aspect, the present disclosure also provides an electronic device, including the above display panel.

In a third aspect, the present disclosure also provides a method for manufacturing a display panel, used for manufacturing the above display panel, and including: forming an array structure layer on a substrate; the substrate includes a transistor; forming a first electrode including a first sub-electrode, a second sub-electrode and a third sub-electrode on one side of the array structure layer away from the substrate; forming an organic light-emitting layer on one side of the first electrode away from the substrate; forming a second electrode on one side of the organic light-emitting layer away from the substrate to form a light-emitting structure layer including the first electrode, the organic light-emitting layer and the second electrode.

In some possible implementations, forming the first electrode including the first sub-electrode, the second sub-electrode and the third sub-electrode on one side of the array structure layer away from the substrate includes: sequentially coating an anti-reflection thin film and a photoresist on one side of the array structure layer away from the substrate; performing exposing and developing processing of the anti-reflection thin film and the photoresist; sequentially depositing a first metal thin film and a second metal thin film on the anti-reflection thin film and the photoresist after exposing processing; immersing the substrate, on which the first metal thin film and the second metal thin film are deposited, in stripping solution to strip the photoresist; performing developing processing of the substrate stripped of the photoresist to strip the anti-reflection thin film to form a third sub-electrode and a first sub-electrode; forming a second sub-electrode on one side of the first sub-electrode away from the substrate.

In some possible implementations, the substrate, on which the first metal thin film and the second metal thin film are deposited, is immersed in the stripping solution for less than 30 minutes.

In some possible implementations, forming the second sub-electrode on one side of the first sub-electrode away from the substrate includes: depositing a transparent conductive thin film on one side of the first sub-electrode away from the substrate by using a sputtering process; coating photoresist on the transparent conductive thin film; performing exposing and developing processing of the photoresist; etching the transparent conductive thin film by using a dry etching process; stripping the photoresist to form the second sub-electrode. The orthographic projection of the second sub-electrode on the substrate covers the orthographic projection of the first sub-electrode on the substrate.

In some possible implementations, an interval time between a start time of depositing the transparent conductive thin film by using the sputtering process on one side of the first sub-electrode away from the substrate and an end time of immersing the substrate, on which the first metal thin film and the second metal thin film are deposited, in the stripping solution to strip the photoresist, is less than 120 minutes.

In some possible implementations, before forming the organic light-emitting layer on one side of the first electrode away from the substrate, the method further includes: depositing a pixel definition thin film on one side of the first electrode away from the substrate; coating photoresist on the pixel definition thin film; performing exposing and developing processing of the photoresist; etching the pixel definition thin film by using a dry etching process; stripping the photoresist to form a pixel definition layer.

In some possible implementations, after forming the second electrode on one side of the organic light-emitting layer away from the substrate, the method further includes: forming an encapsulating layer on one side of the second electrode away from the substrate; forming a color filter layer on one side of the encapsulating layer away from the substrate; forming a cover panel on one side of the color filter layer away from the substrate.

Other aspects will become apparent upon reading and understanding accompanying drawings and the detailed description.

### Brief Description of Drawings

Accompanying drawings are used to provide an understanding of technical solutions of the present disclosure and form a part of the specification. Together with embodiments of the present disclosure, they are used to explain technical solutions of the present disclosure and do not constitute a limitation on the technical solutions of the present disclosure.
FIG. 1 is a schematic structural diagram of a display panel according to an embodiment of the present disclosure.
FIG. 2 is a schematic diagram of a circuit principle of a substrate according to an exemplary embodiment.
FIG. 3 is a schematic diagram of circuit implementation of a voltage control circuit and a pixel driving circuit according to an exemplary embodiment.
FIG. 4 is a schematic structural diagram of an organic light-emitting layer according to an exemplary embodiment.
FIG. 5 is a schematic structural diagram of a display panel according to an exemplary embodiment.
FIG. 6 is a schematic structural diagram of a display panel according to another exemplary embodiment.
FIG. 7 is a flowchart of a manufacturing method of a display panel according to an embodiment of the present disclosure.
FIGs. 8 to 23 are schematic diagrams of a manufacturing method of a display panel according to an exemplary embodiment.

### Detailed Description

To make the objects, technical solutions and advantages of the present disclosure more clear, embodiments of the present disclosure will be described in detail below with reference to the accompanying drawings. An embodiment may be implemented in multiple different forms. A person of ordinary skills in the art will readily understand a fact that modes and contents may be transformed into a variety of forms without departing from the spirit and the scope of the present disclosure. Therefore, the present disclosure should not be construed as being limited only to what is described in the following embodiments. Without conflict, embodiments in the present disclosure and features in the embodiments may be combined with each other arbitrarily.

In the drawings, sizes of various constituent elements, or a thickness or an area of a layer, is sometimes exaggerated for clarity. Therefore, an implementation of the present disclosure is not necessarily limited to the size, and the shape and the size of each component in the drawings do not reflect true proportions. In addition, the drawings schematically show ideal examples, and an implementation of the present disclosure is not limited to the shapes or values shown in the drawings.

Unless otherwise defined, technical terms or scientific terms used in the present disclosure shall have ordinary meanings understood by those of ordinary skills in the field to which the present disclosure belongs. The words "first", "second" and the like used in the present disclosure do not indicate any order, quantity or importance, but are only used to distinguish different components. Similar words such as "including" or "containing" mean that elements or articles appearing before the word cover elements or articles listed after the word and their equivalents, and do not exclude other elements or articles. Similar words such as "connected" or "connected" are not limited to physical or mechanical connections, but may include electrical connections, whether direct or indirect. "Up", "down", "left", "right", etc. are only used to represent a relative position relationship that may change accordingly when an absolute position of an object being described changes.

In this specification, a transistor refers to an element at least including three terminals, namely a gate electrode, a drain electrode and a source electrode. A transistor has a channel region between a drain electrode (drain electrode terminal, drain region or drain electrode) and a source electrode (source electrode terminal, source region or source electrode), and current may flow through the drain electrode, the channel region and the source electrode. A channel region refers to a region through which current mainly flows.

In this specification, a first pole may be a drain electrode and a second pole may be a source electrode, or the first pole may be a source electrode and the second pole may be a drain electrode. Functions of the "source electrode" and the "drain electrode" are sometimes interchanged, in a case that transistors with opposite polarities are used, or in a case that a current direction changes during circuit operation, or the like. Therefore, in this specification, the "source electrode" and the "drain electrode" may be interchanged.

In this specification, a "connection" includes a case in which constituent elements are connected together through an element with a certain electrical effect. The "element with a certain electrical effect" is not particularly limited as long as it may transmit and receive electrical signals between connected constituent elements. Examples of the "element with a certain electrical effect" include not only electrodes and wiring, but also switching elements such as transistors, resistors, inductors, capacitors, and other elements with various functions.

In this specification, a "film" and a "layer" may be interchanged. For example, a "conductive layer" may sometimes be replaced by a "conductive film". Similarly, an "insulating film" may sometimes be replaced by an "insulating layer".

A silicon-based OLED includes a silicon-based backplane integrated with a driving circuit and an OLED light-emitting element array formed on the silicon-based backplane. herein, the OLED light-emitting element array includes an anode, an organic light-emitting layer and a cathode.

As PPI of the silicon-based OLED is very high, a top reflection structure may be used. The anode is configured to realize a reflection function. Generally, the anode adopts a laminated structure of titanium/aluminum/titanium, which leads to a low reflectivity of the anode, thus affecting display brightness of the silicon-based OLED and reducing display effect of the silicon-based OLED.

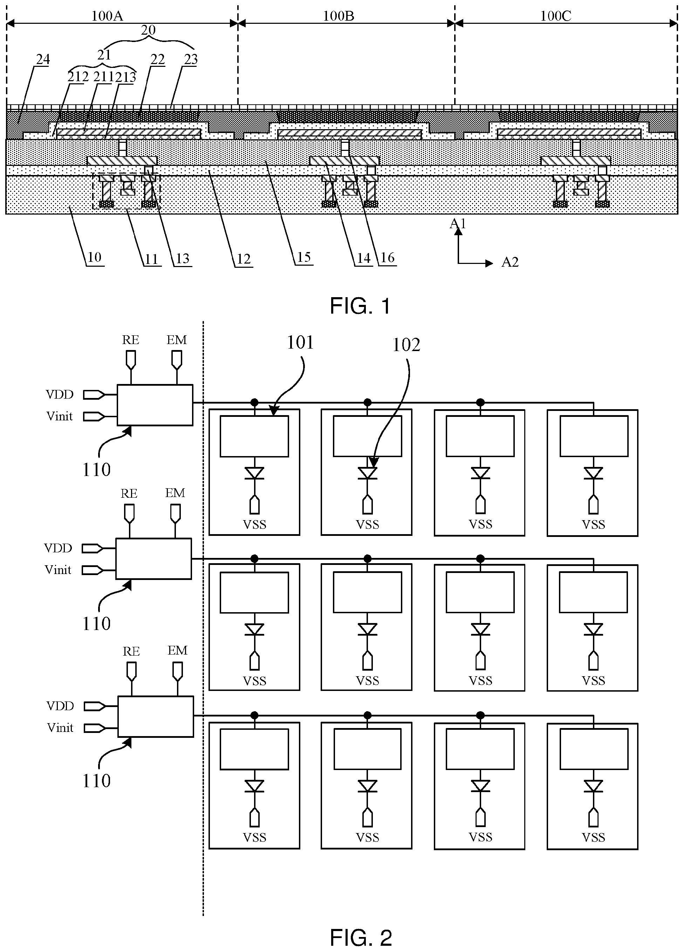

FIG. 1 is a schematic structural diagram of a display panel according to an embodiment of the present disclosure. As shown in FIG. 1, the display panel according to the embodiment of the present disclosure includes a substrate 10, and an array structure layer and a light-emitting structure layer 20 disposed on the substrate 10. The substrate 10 includes a transistor 11, the array structure layer includes a first conductive post 13, a connecting electrode 14 and a second conductive post 16 which are sequentially disposed, and the light-emitting structure layer 20 includes a first electrode 21, an organic light-emitting layer 22 and a second electrode 23. The first electrode 21 is located on one side of the organic light-emitting layer 22 close to the substrate 10, and the second electrode 23 is located on one side of the organic light-emitting layer 22 away from the substrate 10.

The first electrode 21 includes a first sub-electrode 211, a second sub-electrode 212 and a third sub-electrode 213. The second sub-electrode 212 is located on one side of the first sub-electrode 211 away from the substrate 10. The third sub-electrode 213 is located on one side of the first sub-electrode 211 close to the substrate 10.

Reflectivity of the first sub-electrode 211 is greater than threshold reflectivity and greater than reflectivity of the second sub-electrode 212, and the reflectivity of the second sub-electrode 212 is less than reflectivity of the third sub-electrode 213.

The first electrode 21 is connected with the connecting electrode 14 through the second conductive post 16, and the connecting electrode 14 is connected with a drain electrode of the transistor 11 through the first conductive post 13.

The first sub-electrode 211 is configured to reflect light emitted by the organic light-emitting layer 22, and the second sub-electrode 212 is configured to transmit light reflected by the first sub-electrode 211. The third sub-electrode 213 is configured to enhance adhesion between the first sub-electrode 211 and the array structure layer to avoid agglomeration and shedding of the first sub-electrode 211.

In an exemplary embodiment, the substrate 10 may be a silicon-based substrate or a glass substrate, and an active layer of the transistor 11 is formed inside the substrate 10.

In an exemplary embodiment, the transistor 11 may be a Metal Oxide Semiconductor (MOS).

In an exemplary embodiment, the display panel includes: a display region and a non-display region. The display panel includes multiple sub-pixels located in the display region. The non-display region includes a control circuit. FIG. 1 only shows the display region, and the display panel including three sub-pixels 100A, 100B and 100C is taken as an example for illustration.

In an exemplary embodiment, three sub-pixels of different colors make up one pixel, and the three sub-pixels may be a red sub-pixel, a green sub-pixel and a blue sub-pixel, respectively. In some possible implementations, one pixel may include 4, 5 or more sub-pixels, which may be designed and determined according to an actual application environment.

In an exemplary embodiment, as shown in FIG. 1, transistors located in an array structure layer on a substrate 10 may constitute a pixel driving circuit.

FIG. 2 is a schematic diagram of a circuit principle of a substrate according to an exemplary embodiment. As shown in FIG. 2, multiple sub-pixels in the display region are regularly arranged to form multiple display rows and multiple display columns. Each sub-pixel includes a pixel driving circuit 101 and a light-emitting device 102 connected with the pixel driving circuit 101. The pixel driving circuit 101 at least includes a driving transistor. The control circuit at least includes multiple voltage control circuits 110, each of which is connected with multiple pixel driving circuits 101. For example, one voltage control circuit 110 is connected with pixel driving circuits 101 in one display row, first poles of driving transistors in the pixel driving circuits 101 of the display row are jointly connected to the voltage control circuit 110, a second pole of each driving transistor is connected with an anode of the light-emitting device 102 of the present sub-pixel, and a cathode of the light-emitting device 102 is connected to an input end of a second power supply signal VSS. The voltage control circuit 110 is connected with an input end of a first power supply signal VDD, an input end of an initialization signal Vinit, an input end of a reset control signal RE and an input end of a light-emitting control signal EM, respectively. The voltage control circuit 110 is configured to output the initialization signal Vinit to the first pole of the driving transistor in response to the reset control signal RE to control the corresponding light-emitting device 102 to reset. The voltage control circuit 110 is further configured to output the first power supply signal VDD to the first pole of the driving transistor in response to the light-emitting control signal EM to drive the light-emitting device 102 to emit light. By jointly connecting, by pixel driving circuits 101 in one display row to the voltage control circuit 110, the structure of the pixel driving circuits 101 in the display region may be simplified, and an occupied area of the pixel driving circuits 101 in the display region may be reduced, so that more pixel driving circuits 101 and light-emitting devices 102 are caused to be disposed in the display region to realize high PPI display. The voltage control circuit 110 outputs the initialization signal Vinit to the first pole of the driving transistor under the control of the reset control signal RE, and controls the corresponding light-emitting device 102 to reset, which may avoid an influence of voltage applied onto the light-emitting device 102 during previous frame light-emitting on next frame light-emitting, and may improve afterimage phenomenon.

In an exemplary embodiment, one voltage control circuit 110 may be connected to pixel driving circuits 101 in two adjacent sub-pixels in a same display row, or may be connected to pixel driving circuits 101 in three or more sub-pixels in a same display row.

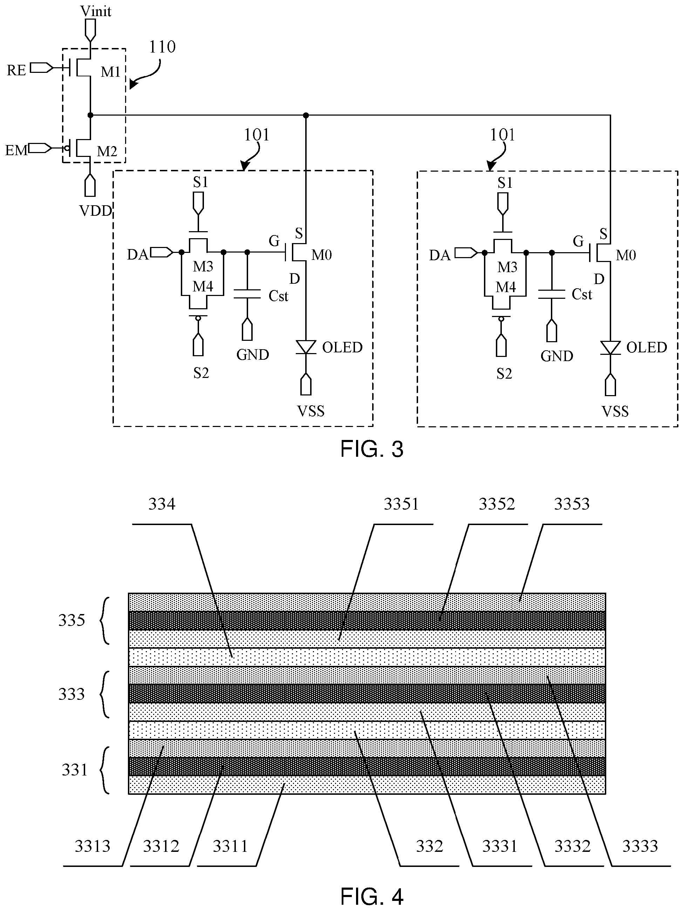

FIG. 3 is a schematic diagram of circuit implementation of a voltage control circuit and a pixel driving circuit according to an exemplary embodiment. As shown in FIG. 3, the light-emitting device may include an OLED. An anode of the OLED is connected with a second pole D of a driving transistor M0, and a cathode of the OLED is connected with the input end of the second power supply signal VSS.

In an exemplary embodiment, voltage of the second power signal VSS may be negative voltage or ground voltage V_{GND} (generally 0V). Voltage of the initialization signal Vinit may be the ground voltage VGND.

In an exemplary embodiment, the OLED may be Micro-OLED or Mini-OLED to facilitate realization of high PPI display.

In an exemplary embodiment, the voltage control circuit 110 is connected with two pixel driving circuits 101 in a display row. The pixel driving circuit 101 includes a driving transistor M0, a third transistor M3, a fourth transistor M4 and a storage capacitor Cst, and the voltage control circuit 110 includes a first transistor M1 and a second transistor M2. The driving transistor M0, the first transistor M1, the second transistor M2, the third transistor M3 and the fourth transistor M4 are all transistors fabricated in the substrate.

A control pole of the first transistor M1 is connected with the input end of the reset control signal RE for receiving the reset control signal RE, a first pole of the first transistor M1 is connected with the input of the initialization signal Vinit for receiving the initialization signal Vinit, and a second pole of the first transistor M1 is connected with a first pole S of the corresponding driving transistor M0 and a second pole of the second transistor M2 respectively. A control pole of the second transistor M2 is connected with the input end of the light-emitting control signal EM for receiving the light-emitting control signal EM, a first pole of the second transistor M2 is connected with the input end of the first power supply signal VDD for receiving the first power supply signal VDD, and a second pole of the second transistor M2 is connected with a first pole S of the corresponding driving transistor M0 and the second pole of the first transistor M1 respectively. In an exemplary embodiment, types of the first transistor M1 and the second transistor M2 may be different, for example, the first transistor M1 is an N-type transistor and the second transistor M2 is a P-type transistor, or the first transistor M1 is a P-type transistor and the second transistor M2 is an N-type transistor. In some possible implementations, the types of the first transistor M1 and the second transistor M2 may be same, which may be designed and determined according to an actual application environment.

The pixel driving circuit 101 includes the driving transistor M0, the third transistor M3, the fourth transistor M4 and the storage capacitor Cst. A control pole G of the driving transistor M0, a first pole S of the driving transistor M0 is connected with the second pole of the first transistor M1 and the second pole of the second transistor M2, and a second pole D of the driving transistor M0 is connected with the anode of the OLED. A control pole of the third transistor M3 is connected with an input end of a first control pole scanning signal S1 for receiving the first control pole scanning signal S1, a first pole of the third transistor M3 is connected with an input end of a data signal DA for receiving the data signal DA, and a second pole of the third transistor M3 is connected with the control pole G of the driving transistor M0. A control pole of the fourth transistor M4 is connected with an input end of a second control pole scanning signal S2 for receiving the second control pole scanning signal S2, a first pole of the fourth transistor M4 is connected with the input of the data signal DA for receiving the data signal DA, and a second pole of the fourth transistor M4 is connected with the control pole G of the driving transistor M0. A first end of the storage capacitor Cst is connected with the control pole G of the driving transistor M0, and a second end of the storage capacitor Cst is connected with a ground end GND. In an exemplary embodiment, the driving transistor M0 may be an N-type transistor, and types of the third transistor M3 and the fourth transistor M4 may be different, for example, the third transistor M3 is an N-type transistor and the fourth transistor M4 is a P-type transistor. When voltage of the data signal DA is voltage corresponding to a high gray scale, through the fourth transistor M4 of the P-type turned on to transmit the data signal DA to the control pole G of the driving transistor M0, the voltage of the data signal DA may be prevented from being affected by, for example, threshold voltage of the third transistor M3 of the N-type. When voltage of the data signal DA is voltage corresponding to a low gray scale, through the third transistor M3 of the N-type turned on to transmit the data signal DA to the control pole G of the driving transistor M0, the voltage of the data signal DA may be prevented from being affected by threshold voltage of the fourth transistor M4 of the P-type. In this way, a voltage range input onto the control pole G of the driving transistor M0 may be increased.

In an exemplary embodiment, the types of the third transistor M3 and the fourth transistor M4 may be: the third transistor M3 is a P-type transistor and the fourth transistor M4 is an N-type transistor.

In an exemplary embodiment, the pixel driving circuit may be a 3T1C, 5T1C or 7T1C circuit structure, or may be a circuit structure with an internal compensation or external compensation function.

In an exemplary embodiment, as shown in FIG. 1, the array structure layer further includes a first insulating layer 12 located on one side of the transistor 11 away from the substrate 10 and a second insulating layer 15 located on one side of the first insulating layer 12 away from the substrate 10.

A first via hole is disposed on the first insulating layer 12, wherein the first conductive post 13 is disposed in the first via hole. A second via hole is disposed on the second insulating layer 15, wherein the second conductive post 16 is disposed in the second via hole.

In an exemplary embodiment, the transistor 11 includes an active layer, a gate electrode, a source electrode, a drain electrode, and a gate connecting electrode. Herein, the source electrode and the drain electrode are respectively connected with the active layer, and the gate connecting electrode is connected with the gate electrode through a conductive post. The transistor may be in a bottom gate structure or may be in a top gate structure.

In an exemplary embodiment, a manufacturing material of the first insulating layer 12 and the second insulating layer 15 may be silicon oxide (SiOx), silicon nitride (SiNx) or silicon oxynitride (SiON). A structure of the first insulating layer 12 and the second insulating layer 15 may be a single-layer structure or a multi-layer composite structure.

In an exemplary embodiment, a manufacturing material of the first conductive post 13 and the second conductive post 16 may be tungsten.

In an exemplary embodiment, a manufacturing material of the connecting electrode 14 may be silver or aluminum. A structure of the connecting electrode 14 may be a single-layer structure or a multi-layer composite structure.

FIG. 4 is a schematic structural diagram of an organic light-emitting layer according to an exemplary embodiment. As shown in FIG. 4, an organic light-emitting layer according to an exemplary embodiment includes a first light-emitting sublayer 331, a first charge generation layer 332, a second light-emitting sublayer 333, a second charge generation layer 334 and a third light-emitting sublayer 335 sequentially stacked between an anode and a cathode.

The first light-emitting sublayer 331 is used for emitting light of a first color, and includes a first hole transporting layer (HTL) 3311, a first emitting material layer (EML) 3312, and a first electron transporting layer (ETL) 3313 which are sequentially stacked. The second light-emitting sublayer 333 is used for emitting light of a second color, and includes a second hole transporting layer 3331, a second light-emitting material layer 3332 and a second electron transporting layer 3333 which are sequentially stacked. The third light-emitting sublayer 335 is used for emitting light of a third color, and includes a third hole transporting layer 3351, a third light-emitting material layer 3352 and a third electron transporting layer 3353 which are sequentially stacked. The first charge generating layer 332 is disposed between the first light-emitting sublayer 331 and the second light-emitting sublayer 333, and is used for connecting the two light-emitting sublayers in series to realize carrier transfer. The second charge generating layer 334 is disposed between the second light-emitting sublayer 333 and the third light-emitting sublayer 335, and is used for connecting the two light-emitting sublayers in series to realize carrier transfer. Since the organic light-emitting layer includes a first light-emitting material layer emitting light of a first color, a second light-emitting material layer emitting light of a second color and a third light-emitting material layer emitting light of a third color, light eventually emitted by the organic light-emitting layer is mixed light. For example, it may be disposed that the first light-emitting material layer is a red light material layer emitting red light, the second light-emitting material layer is a green light material layer emitting green light, and the third light-emitting material layer is a blue light material layer emitting blue light, and therefore, the organic light-emitting layer eventually emits white light.

In practice, the structure of the organic light-emitting layer may be designed according to an actual need. In each light-emitting sublayer, in order to improve efficiency of injecting electrons and holes into the light-emitting material layer, a hole injection layer and an electron injection layer may also be disposed. In order to simplify the structure of the organic light-emitting layer, the first electron transporting layer 3313, the first charge generating layer 332 and the second hole transporting layer 3331 may be cancelled, that is, the second light-emitting material layer 3332 may be disposed directly on the first light-emitting material layer 3312.

In an exemplary embodiment, the organic light-emitting layer may adopt an organic light-emitting layer emitting light of a first color and an organic light-emitting layer emitting complementary light of the first color, and the two organic light-emitting layers are sequentially stacked relative to the substrate, thereby emitting white light as a whole.

In an exemplary embodiment, the second electrode 23 may be a planar electrode.

In an exemplary embodiment, the second electrode 23 is a transmissive electrode for transmitting light emitted by the organic light-emitting layer 22. The light emitted by the organic light-emitting layer 22 includes light emitted by the organic light-emitting layer 22 to the second electrode 23 and light emitted by the organic light-emitting layer 22 to the first electrode 21 and reflected by the first electrode 21.

In an exemplary embodiment, a manufacturing material of the second electrode 23 may be indium tin oxide or zinc tin oxide, or another transparent conductive material.

In an exemplary embodiment, an orthographic projection of the first electrode 21 on the substrate 10 covers an orthographic projection of the organic light-emitting layer 22 on the substrate 10, that is, a size of the first electrode 21 is greater than that of the organic light-emitting layer 22, which may improve display brightness of the display panel.

In an exemplary embodiment, an orthographic projection of the first sub-electrode 211 on the substrate 10 covers an orthographic projection of the organic light-emitting layer 22 on the substrate 10, that is, a size of the first sub-electrode 211 is greater than that of the organic light-emitting layer 22, which may cause that the first sub-electrode 211 may reflect the light emitted by the organic light-emitting layer 22 to the first sub-electrode 211 to a great extent, improving reflection efficiency of the first sub-electrode.

In an exemplary embodiment, the threshold reflectivity may be 80%.

A display panel according to an embodiment of the present disclosure includes a substrate, an array structure layer and a light-emitting structure layer sequentially disposed on the substrate. The substrate includes a transistor, the array structure layer includes a first conductive post, a connecting electrode and a second conductive post which are sequentially disposed, the light-emitting structure layer includes a first electrode, an organic light-emitting layer and a second electrode, the first electrode is located on one side of the organic light-emitting layer close to the substrate, and the second electrode is located on one side of the organic light-emitting layer away from the substrate. The first electrode includes a first sub-electrode, a second sub-electrode and a third sub-electrode. The second sub-electrode is located on one side of the first sub-electrode away from the substrate, and the third sub-electrode is located on one side of the first sub-electrode close to the substrate. Reflectivity of the first sub-electrode is greater than threshold reflectivity and greater than reflectivity of the second sub-electrode, and the reflectivity of the second sub-electrode is less than reflectivity of the third sub-electrode. The first electrode is connected with the connecting electrode through the second conductive post, and the connecting electrode is connected with a drain electrode of the transistor through the first conductive post. In a technical solution according to an embodiment of the present disclosure, though a first electrode including a first sub-electrode, reflectivity of which is greater than threshold reflectivity, as well as a second sub-electrode and a third sub-electrode, reflectivity of the first electrode may be improved, thereby improving display brightness of silicon-based OLED and improving display effect of the silicon-based OLED.

In an exemplary embodiment, as shown in FIG. 1, an orthographic projection of the second sub-electrode 212 on the substrate 10 covers an orthographic projection of the first sub-electrode 211 on the substrate 10, that is, a size of the second sub-electrode 212 is greater than that of the first sub-electrode 211. The second sub-electrode 212 surrounds the first sub-electrode 211, which may prevent the first sub-electrode from being damaged by a film layer process after the second sub-electrode which results in that reflectivity is reduced, may improve performance of the first sub-electrode, and may also play a role of protecting the first sub-electrode 211.

In an exemplary embodiment, the display panel further includes multiple gate lines and multiple data lines disposed on the substrate. The gate lines and the data lines are staggered horizontally and vertically.

In an exemplary embodiment, an orthographic projection of the third sub-electrode 213 on the substrate 10 at least covers the orthographic projection of the first sub-electrode 211 on the substrate 10, and the orthographic projection of the second sub-electrode 212 on the substrate 10 covers the orthographic projection of the third sub-electrode 213 on the substrate 10.

In an exemplary embodiment, a projection area of the third sub-electrode 213 on the substrate 10 may be equal to a projection area of the first sub-electrode 211 on the substrate 10, or the projection area of the third sub-electrode 213 on the substrate 10 may be greater than the projection area of the first sub-electrode 211 on the substrate 10.

In an exemplary embodiment, a length of the first sub-electrode 211 along a first direction A1 is greater than a length of the second sub-electrode 212 along the first direction A1, and a length of the first sub-electrode 211 along a second direction A2 is less than a length of the second sub-electrode 212 and along the second direction A2.

In an exemplary embodiment, a length of the second sub-electrode 212 along the second direction A2 is 1.2 times a length of the first sub-electrode 211 along the second direction A2, which may ensure that the second sub-electrode completely covers the first sub-electrode.

In an exemplary embodiment, as shown in FIG. 1, the first direction A1 is perpendicular to the substrate 10, and the second direction A2 is an extending direction of the gate line.

In an exemplary embodiment, due to existence of the second sub-electrode 212, a manufacturing material of the first sub-electrode 211 may include silver, so that the reflectivity of the first electrode 21 may be 95%, which greatly improves the reflectivity of the first electrode.

In an exemplary embodiment, the length of the first sub-electrode 211 along the first direction A1 is 400 angstroms to 600 angstroms, or the length of the first sub-electrode 211 along the first direction A1 may be floated up and down by 10%. In an exemplary embodiment, the length of the first sub-electrode 211 along the first direction A1 is 500 angstroms.

In an exemplary embodiment, the length of the first sub-electrode 211 along the second direction A2 is 1.5 microns to 2.5 microns, or the length of the first sub-electrode 211 along the second direction A2 may be floated up and down by 20%. In an exemplary embodiment, the length of the first sub-electrode 211 along the second direction A2 is 2 microns.

In an exemplary embodiment, the reflectivity of the first sub-electrode 211 will increase as the length of the first sub-electrode 211 along the first direction A1 increases.

In an exemplary embodiment, a manufacturing material of the second sub-electrode 212 may include indium tin oxide.

In an exemplary embodiment, a work function of the second sub-electrode 212 is greater than 5, and a light transmittance of the second sub-electrode 212 is greater than 99%, so that an energy level in the organic light-emitting layer may be matched, causing that holes may be injected into the organic light-emitting layer better, and power consumption of the display panel may be reduced.

In an exemplary embodiment, the length of the second sub-electrode 212 along the first direction A1 is 120 angstroms to 180 angstroms, or the length of the second sub-electrode 212 along the first direction A1 may be floated up and down by 20%. In an exemplary embodiment, the length of the second sub-electrode 212 along the first direction A1 is 150 angstroms.

In an exemplary embodiment, the length of the second sub-electrode 212 along the second direction A2 is 1.8 microns to 4 microns, or the length of the second sub-electrode 212 along the second direction A2 may be floated up and down by 20%. In an exemplary embodiment, the length of the second sub-electrode 212 along the second direction A2 is 2.4 microns.

Since the second sub-electrode 212 has a step when forming a film at an edge of the first sub-electrode 211, in an exemplary embodiment, the length of the second sub-electrode 212 along the first direction may ensure that the second sub-electrode 212 may wrap the first sub-electrode 21 at the edge of the first sub-electrode 211, which may prevent the first sub-electrode 211 from being oxidized and corroded to cause failure and prolong service life of the first electrode.

In an exemplary embodiment, a manufacturing material of the third sub-electrode 213 includes titanium.

In an exemplary embodiment, a length of the third sub-electrode along the first direction A1 is 80 angstroms to 120 angstroms, or the length of the third sub-electrode along the first direction A1 may be floated up and down by 20%. In an exemplary embodiment, the length of the third sub-electrode along the first direction A1 is 100 angstroms.

In an exemplary embodiment, a length of the third sub-electrode along the second direction A2 is 1.5 microns to 2.5 microns, or the length of the third sub-electrode along the second direction A2 may be floated up and down by 20%. In an exemplary embodiment, the length of the third sub-electrode along the second direction A2 is 2 microns.

In an exemplary embodiment, a manufacturing material of the first sub-electrode 211 includes silver, a manufacturing material of the second sub-electrode 212 includes indium tin oxide, and a manufacturing material of the third sub-electrode 213 includes titanium.

In an exemplary embodiment, as shown in FIG. 1, the display panel according to an exemplary embodiment further includes a pixel definition layer 24 for defining a pixel region. The pixel definition layer 24 is located on one side of the array structure layer away from the substrate 10.

In an exemplary embodiment, a manufacturing material of the pixel definition layer 24 may include silicon oxide.

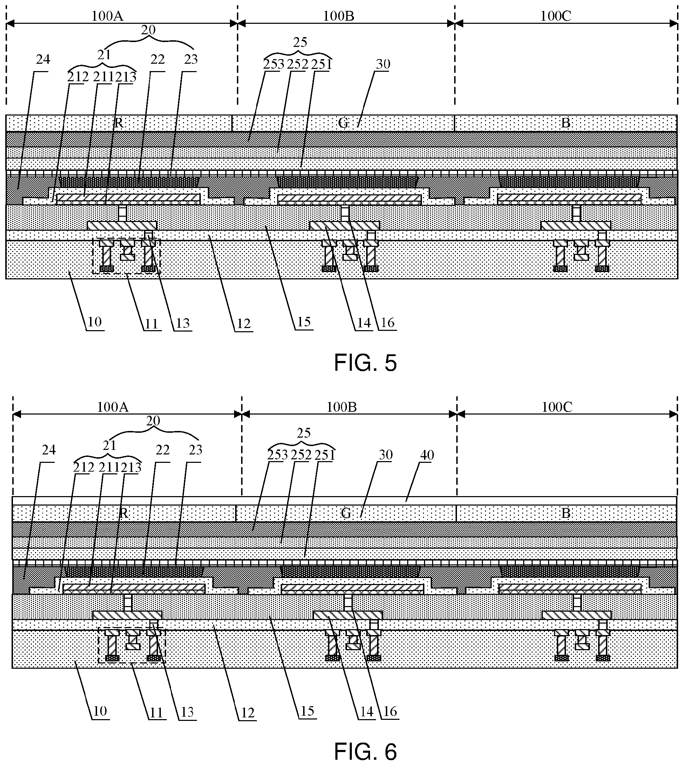

FIG. 5 is a schematic structural diagram of a display panel according to another exemplary embodiment. As shown in FIG. 5, the display panel according to an exemplary embodiment further includes an encapsulating layer 25 and a color filter layer 30.

The encapsulating layer 25 is located on one side of the light-emitting structure layer 20 away from the substrate 10 and is configured to isolate water and oxygen. The color filter layer 30 is located on one side of the encapsulating layer 25 away from the substrate 10.

In an exemplary embodiment, as shown in FIG. 5, the encapsulating layer 25 includes a first inorganic encapsulating layer 251, a second inorganic encapsulating layer 252 and a third organic encapsulating layer 253.

The first inorganic encapsulating layer 251 is located on one side of the second inorganic encapsulating layer 252 close to the substrate 10. The third organic encapsulating layer 253 is located on one side of the second inorganic encapsulating layer 252 away from the substrate 10.

In an exemplary embodiment, a manufacturing material of the first inorganic encapsulating layer 251 may include silicon nitride. The first inorganic encapsulating layer may avoid damage to the light-emitting structure layer when the second inorganic encapsulating layer is manufactured. Since the first inorganic encapsulating layer 251 has an inorganic characteristic, it not only has a good encapsulation characteristic, but also has good adhesion with the second electrode, which ensures encapsulation effect of the encapsulating layer.

In an exemplary embodiment, a manufacturing material of the second inorganic encapsulating layer 252 may include aluminum oxide. The second inorganic encapsulating layer 252 may block water and oxygen from entering the light-emitting structure layer, which may prolong service life of the light-emitting structure layer.

In an exemplary embodiment, a length of the second inorganic encapsulating layer 252 along the first direction A1 is greater than a length of the first inorganic encapsulating layer 251 along the first direction A1.

In an exemplary embodiment, a manufacturing material of the third organic encapsulating layer 253 may include parylene. Since the third organic encapsulating layer 253 has an organic characteristic, it not only has a better organic encapsulation characteristic, but also has a better particle coating ability, which may well coat particles on a film layer and prevent the film layer from piercing. In addition, a material with an organic characteristic may well release a stress between inorganic layers, and prevent defects such as microcracks or peeling caused by a higher stress. The third organic encapsulating layer 253 also has a better flatness characteristic, which may provide a flatter substrate for subsequent color filter layer manufacturing and prevent the color filter layer manufacturing process from damaging the second inorganic encapsulating layer.

In an exemplary embodiment, the color filter layer 30 is disposed on the encapsulating layer 25, and the color filter layer 30 realizes full-color display by using a mode of combining white light with a color film. The color filter layer 30 at least includes a first color filter, a second color filter and a third color filter corresponding to the sub-pixels. In an exemplary embodiment, the first color filter may be a green (G) color filter, the second color filter may be a red (R) color filter, and the third color filter may be a blue (B) color filter.

In an exemplary embodiment, the color filter layer 30 may also include a white filter or a filter of another color.

In an exemplary embodiment, the color filter layer 30 may further include a black matrix.

In an exemplary embodiment, using the mode of combining white light with the color film may realize high resolution of more than 2000, which may meet a VR/AR requirement.

FIG. 6 is a schematic structural diagram of a display panel according to another exemplary embodiment. As shown in FIG. 6, the display panel according to an exemplary embodiment further includes a cover panel 40, and the cover panel 40 is located on one side of the color filter layer 30 away from the substrate 10.

In an exemplary embodiment, the cover panel may be a glass cover panel. The cover panel 40 and the substrate 10 are fixed by sealant (not shown in the figure) with each other. The cover panel may play a role of protecting the color filter layer 30.

In an exemplary embodiment, the sealant is disposed between the substrate and the cover panel, which may provide protection for blocking water and oxygen intrusion, and greatly prolong life of a silicon-based OLED display panel. In another exemplary embodiment, the sealant may be disposed on a side of the cover panel, peripheral sides of the cover panel and the substrate are sealed by the sealant, and an end face on side of the sealant away from the substrate is located between a surface of the cover panel adjacent to the substrate and a surface of the cover panel away from the substrate, thus both sealing effect may be ensured and thickness of the display panel may be prevented from increasing because the sealant is higher than the cover panel.

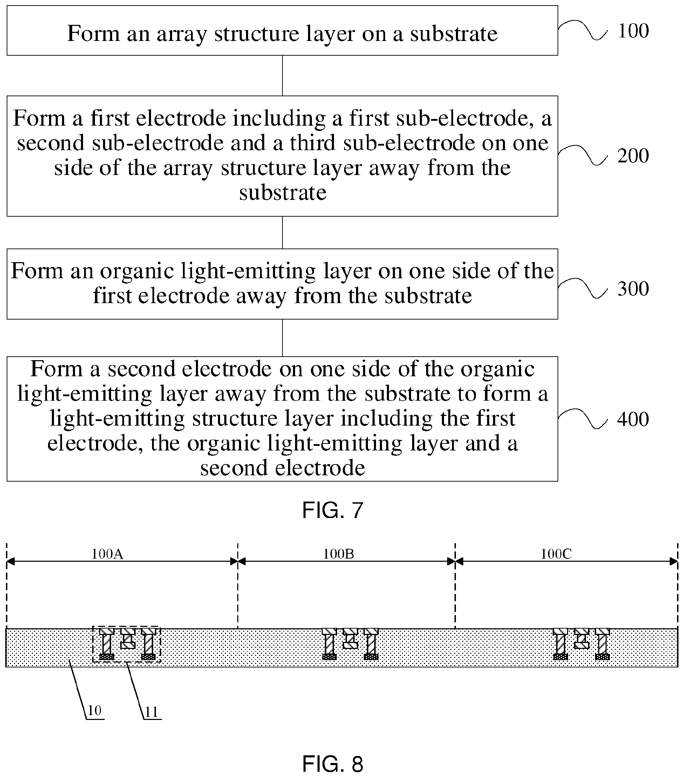

FIG. 7 is a flowchart of a method for manufacturing a display panel according to an embodiment of the present disclosure. As shown in FIG. 7, an embodiment of the present disclosure also provides a method for manufacturing a display panel, which is used for manufacturing the display panel according to any of the previous embodiments, and the method for manufacturing the display panel according to the embodiment of the present disclosure includes following acts.

In act 100, an array structure layer is formed on a substrate.

The substrate includes a transistor. The transistor includes an active layer, a gate electrode, a source electrode, a drain electrode and a gate connecting electrode. Herein, the source electrode and the drain electrode are respectively connected with the active layer, and the gate connecting electrode is connected with the gate electrode through a conductive post. The transistor may be in a bottom gate structure or may be in a top gate structure.

In act 200, a first electrode including a first sub-electrode, a second sub-electrode and a third sub-electrode is formed on one side of the array structure layer away from the substrate.

In act 300, an organic light-emitting layer is formed on one side of the first electrode away from the substrate.

In act 400, a second electrode is formed on one side of the organic light-emitting layer away from the substrate to form a light-emitting structure layer including the first electrode, the organic light-emitting layer and a second electrode.

The method for manufacturing the display panel in the embodiment of the present disclosure is used to manufacture the display panel according to any of the previous embodiments, and its implementation principle and implementation effect are similar, which is not repeated here.

In an exemplary embodiment, act 100 includes that: a transistor is formed on a substrate, a first insulating layer disposed with a first via hole is formed on the substrate on which the transistor is formed; a first conductive post is formed in the first via hole; a connecting electrode is formed on the first insulating layer; a second insulating layer disposed with a second via hole is formed on the first insulating layer formed with the connecting electrode; a second conductive post is formed in the second via hole.

In an exemplary embodiment, act 200 includes that: an anti-reflection thin film and photoresist are sequentially coated on one side of the array structure layer away from the substrate; exposing and developing processing of the anti-reflection thin film and the photoresist is performed; a first metal thin film and a second metal thin film are sequentially deposited on the anti-reflection thin film and the photoresist after exposuring processing; the substrate, on which the first metal thin film and the second metal thin film are deposited, is immersed in stripping solution to strip the photoresist; developing processing of the substrate stripped of the photoresist is performed to strip the anti-reflection thin film to form a third sub-electrode and a first sub-electrode; and a second sub-electrode is formed on one side of the first sub-electrode away from the substrate.

In an exemplary embodiment, an act where the second sub-electrode is formed on one side of the first sub-electrode away from the substrate includes that: a transparent conductive thin film is deposited on one side of the first sub-electrode away from the substrate by using a sputtering process; photoresist is coated on the transparent conductive thin film; exposing and developing processing of the photoresist is performed; the transparent conductive thin film is etched by using a dry etching process; the photoresist is stripped to form a second sub-electrode; an orthographic projection of the second sub-electrode on the substrate covers an orthographic projection of the first sub-electrode on the substrate.

In an exemplary embodiment, dry etching is used to form the second sub-electrode, which may ensure accuracy of the second sub-electrode.

In an exemplary embodiment, an interval time between a start time of depositing the transparent conductive thin film by using the sputtering process on one side of the first sub-electrode away from the substrate and an end time of immersing the substrate, on which the first metal thin film and the second metal thin film are deposited, in the stripping solution to strip the photoresist, is less than 120 minutes to avoid oxidation corrosion of the first sub-electrode.

In an exemplary embodiment, before the anti-reflection thin film and the photoresist are sequentially coated on one side of the array structure layer away from the substrate, the method for manufacturing the display panel further includes that: the substrate disposed with the array structure layer is cleaned.

In an exemplary embodiment, after exposing and developing processing of the anti-reflection thin film and the photoresist is performed, the method for manufacturing the display panel further includes that: dust attached onto the substrate on which the anti-reflection thin film and the photoresist are deposited is removed.

In an exemplary embodiment, coating the anti-reflection thin film before coating the photoresist may achieve purposes of enlarging a lithography process window and improving width control of a lithography strip.

In an exemplary embodiment, after the anti-reflection thin film and the photoresist are exposed, the anti-reflection thin film and the photoresist form a groove. The groove includes a first groove formed on the anti-reflection thin film and a second groove formed on the photoresist. An orthographic projection of the first groove on the substrate covers an orthographic projection of the second groove on the substrate, that is, the groove formed by the anti-reflection thin film and the photoresist is an undercut structure.

In an exemplary embodiment, since etching processing of the first metal thin film is not performed during the manufacturing process of forming the first sub-electrode, it is caused that the first sub-electrode will not be damaged by the etching process, which may ensure that accuracy of the first sub-electrode may meet the requirement of the silicon-based OLED. Therefore, in an exemplary embodiment, a manufacturing material of the second metal thin film may be silver, and reflectivity of silver is as high as 95%, so the reflectivity of the first sub-electrode may be improved.

In an exemplary embodiment, a manufacturing material of the first metal thin film may be titanium.

In an exemplary embodiment, the substrate, on which the first metal thin film and the second metal thin film are deposited, is immersed in the stripping solution for less than 30 minutes. This may avoid damage of the stripping solution to the second metal thin film, wherein the damage of the second metal thin film includes agglomeration damage or shrinkage of the second metal thin film.

In an exemplary embodiment, before act 300, the method for manufacturing the display panel further includes that: a pixel definition thin film is deposited on one side of the first electrode away from the substrate; photoresist is coated on the pixel definition thin film; exposing and developing processing of the photoresist is performed; the pixel definition thin film is etched by using a dry etching process; the photoresist is stripped to form a pixel definition layer.

In an exemplary embodiment, after act 400, the method for manufacturing the display panel further includes that: an encapsulating layer is formed on one side of the second electrode away from the substrate; a color filter layer is formed on one side of the encapsulating layer away from the substrate; a cover panel is formed on one side of the color filter layer away from the substrate.

Next, the structure of the display panel will be explained with reference to FIGs. 8 to 24 through an example of the process for preparing the display panel. The "patterning process" in the present disclosure includes processing of film layer deposition, photoresist coating, mask exposure, development, etching, and photoresist stripping. Any one or more of sputtering, evaporation and chemical vapor deposition may be used for deposition, and any one or more of spray coating and spin coating may be used for coating. "Thin film" refers to a layer of thin film fabricated by a certain material on a base substrate by using a deposition or coating process. If the "thin film" does not need a patterning process during the whole manufacturing process, the "thin film" may also be referred to as a "layer". If the "thin film" needs a patterning process throughout the whole manufacturing process, it is referred to as a "thin film" before the patterning process and as a "layer" after the patterning process. The "layer" after the patterning process contains at least one "pattern".

In act S1, a substrate 10 is provided, and the substrate 10 includes a transistor 11. Transistors constitute a pixel driving circuit. The substrate 10 includes multiple sub-pixels, and each sub-pixel includes one pixel driving circuit, as shown in FIG. 8.

In an exemplary embodiment, the display panel includes a display region and a non-display region, and sub-pixels are located in the display region. In FIG. 8, three sub-pixels of the display region are illustrated: the first sub-pixel 100A, the second sub-pixel 100B and the third sub-pixel 100C, and the transistor 11 included in the pixel driving circuit is illustrated. After the preparation is completed, source electrodes and drain electrodes of the display region are exposed on a surface of the substrate 10.

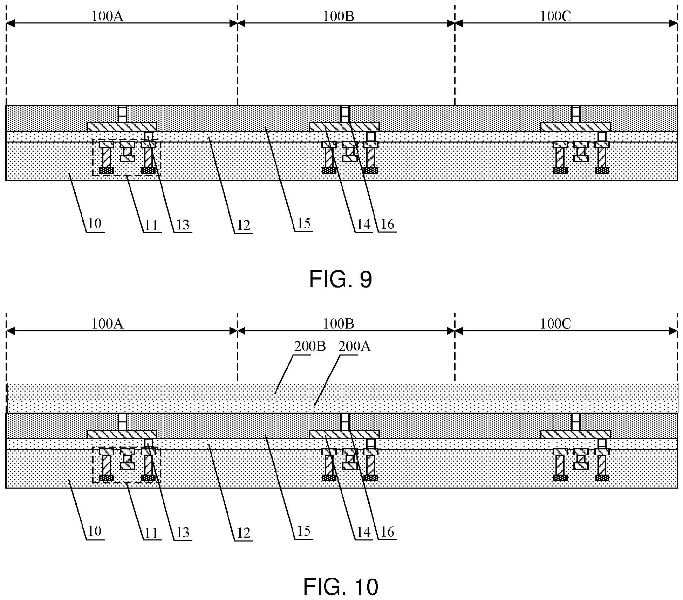

In act S2, a first insulating thin film is deposited on the substrate 10, and patterning of the first insulating thin film is performed by the patterning process to form a first insulating layer 12 covering the substrate 10, wherein the first insulating layer 12 forms multiple first vias, and the multiple first vias expose a drain electrode of each sub-pixel respectively. Then, a first conductive post 13 is formed in the first via hole, and the first conductive post 13 is connected with the drain electrode of each sub-pixel. A conductive thin film is deposited on the first insulating layer 12, and patterning of the conductive thin film is performed by the patterning process to form a connecting electrode 14 with the first conductive post 13. A second insulating thin film is deposited on the connecting electrode 14, and patterning of the second insulating thin film is performed by the patterning process to form a second insulating layer 15 covering the substrate. The second insulating layer 15 forms multiple second vias, wherein the multiple second vias expose the connecting electrode 14 respectively, and second conductive posts 16 connected with the connecting electrode 14 are formed in the second vias to form an array structure layer, as shown in FIG. 9.

In S3, an anti-reflection thin film 200A and photoresist 200B are sequentially coated on the array structure layer, as shown in FIG. 10.

In an exemplary embodiment, a manufacturing material of the anti-reflection thin film may be an organic material or an inorganic material. A layer of anti-reflection thin film is first coated before coating photoresist, which may achieve purposes of enlarging a lithography process window and improving width control of a lithography strip.

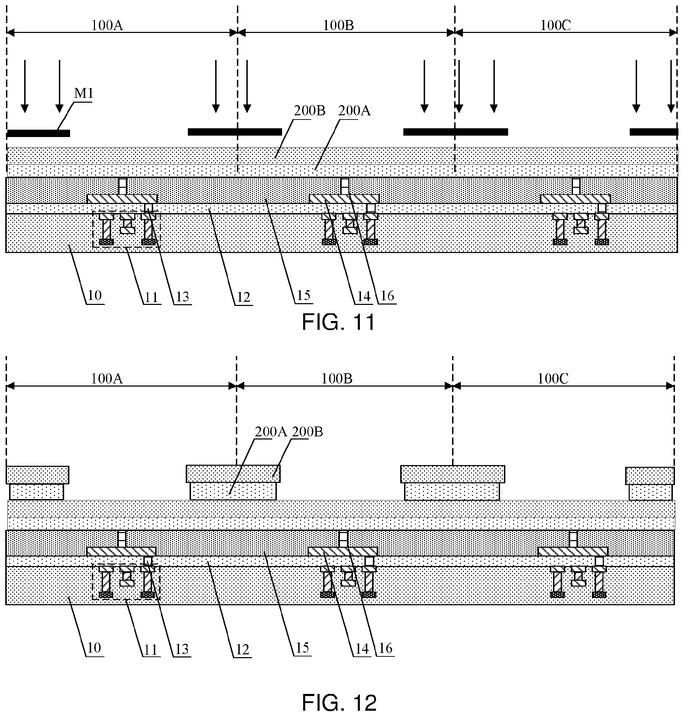

In S4, the anti-reflection thin film 200A and the photoresist 200B are exposed by ultraviolet rays passing through a first mask M1. Be as shown in FIG. 11.

In S5, developing processing of the anti-reflection thin film 200A and the photoresist 200B after development is performed, and then dedusting processing of the substrate is performed. Be as shown in FIG. 12.

The anti-reflection thin film 200A and the photoresist 200B after developing processing are formed with a groove with an undercut structure. The groove includes a first groove formed on the anti-reflection thin film 200A after exposuring processing and a second groove formed on the photoresist 200B after exposuring processing. An orthographic projection of the first groove on the substrate 10 covers an orthographic projection of the second groove on the substrate 10.

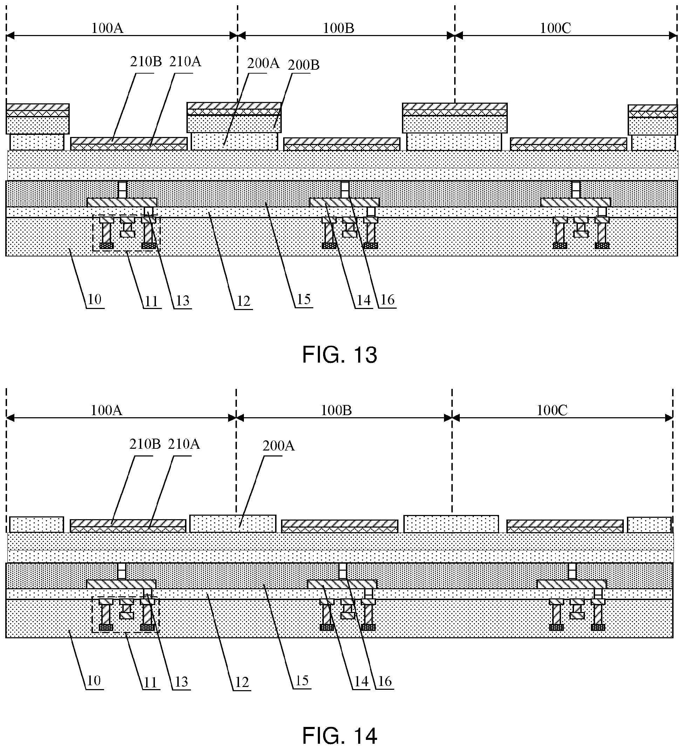

In act S6, a first metal thin film 210A and a second metal thin film 210B are sequentially deposited on the anti-reflection thin film 200A and the photoresist 200B after exposuring processing, as shown in FIG. 13.

In act S7, the substrate 10, on which the first metal thin film 210A and the second metal thin film 210B are deposited, is immersed in stripping solution to strip the photoresist 200B, wherein immersing time is less than 30 minutes, as shown in FIG. 14.

If the stripping solution is immersed for a relatively long time, the second metal thin film 210B will be damaged and agglomerated, causing the second metal thin film 210B to fall off a surface of the first metal thin film 21 0A, or causing the second metal thin film 210B to shrink.

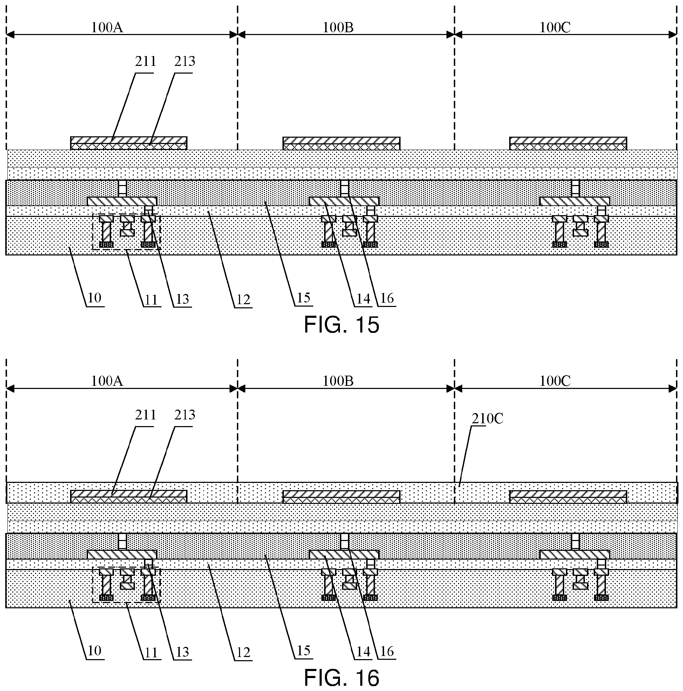

In act S8, developing processing of the anti-reflection thin film 200A is performed, and stripping of the anti-reflection thin film 200A is performed to form a third sub-electrode 213 and a first sub-electrode 211, as shown in FIG. 15.

In act S9, a transparent conductive thin film 210C is deposited on the substrate formed with the first sub-electrode 211 by using a sputtering process, as shown in FIG. 16.

A time interval between an end time of act S7 and a start time of act S9 is less than 120 minutes, so as to prevent the first sub-electrode 211 from being blackened by oxidation corrosion.

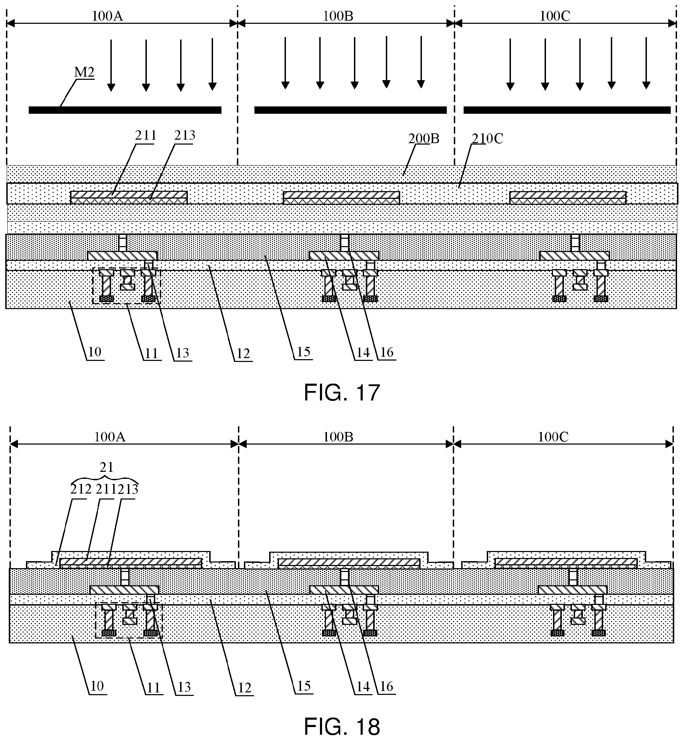

In S10, photoresist 200B is coated on the transparent conductive thin film 210C, and exposing processing of the photoresist 200B is performed by ultraviolet rays passing through a second mask M2, as shown in FIG. 17.

In act S11, developing processing of the photoresist 200B after exposuring processing is performed, the transparent conductive thin film 210C is etched by using a dry etching process, and the photoresist is stripped to form a second sub-electrode 212 to form a first electrode 21, as shown in FIG. 18.

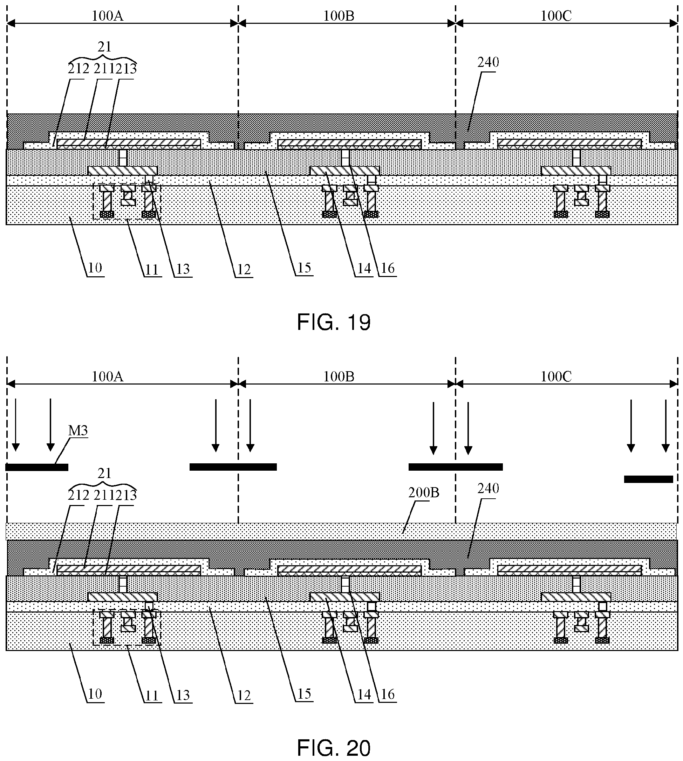

In act S12, a pixel definition thin film 240 is deposited on the substrate formed with the first electrode by using Plasma Enhanced Chemical Vapor Deposition (PECVD), as shown in FIG. 19.

In act S13, photoresist 200B is coated on the pixel definition thin film 240, and exposing processing of the photoresist 200B is performed by ultraviolet rays passing through a second mask M3, as shown in FIG. 20.

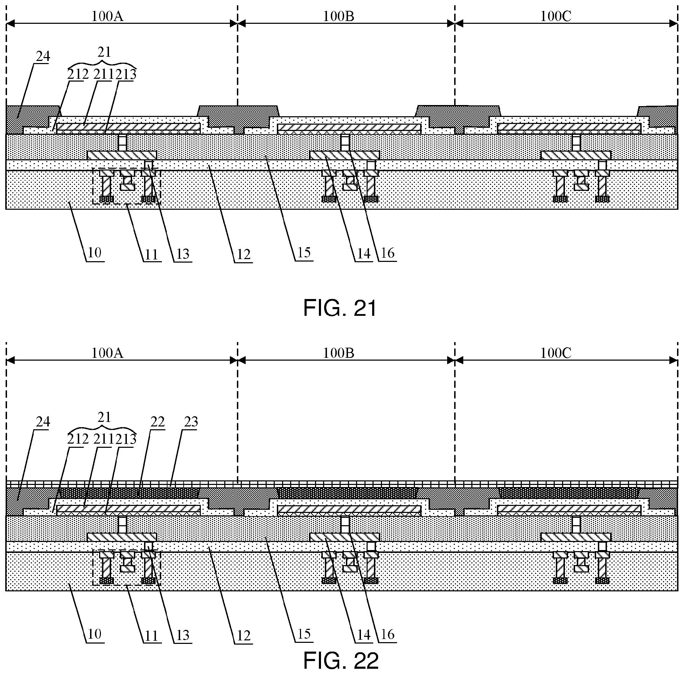

In act S14, developing processing of the photoresist 200B after exposuring processing, the pixel definition thin film 240 is etched by using the dry etching process, and the photoresist is stripped to form the pixel definition layer 24, as shown in FIG. 21.

In each sub-pixel, the pixel definition layer 24 is opened with a pixel opening, and the pixel opening exposes a surface of the first electrode 21.

In act S15, an organic light-emitting layer 22 and a second electrode 23 are sequentially formed on the substrate on which the pixel definition layer is formed, as shown in FIG. 22.

In each sub-pixel, the organic light-emitting layer 22 is electrically connected with the first electrode 21, and the second electrode 23 is electrically connected with the organic light-emitting layer 22.

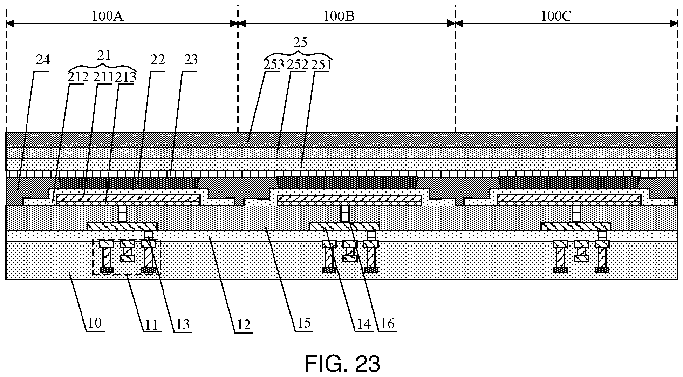

In act S16, a first encapsulating thin film is deposited on the second electrode 23, and the first encapsulating thin film is patterned by a patterning process to form a first encapsulating layer 251; a second encapsulating thin film is deposited on the first encapsulating layer 251, and the second encapsulating thin film is patterned by a patterning process to form a second encapsulating layer 252; a third encapsulating thin film is coated on the second encapsulating layer 252, and the third encapsulating thin film is patterned by mask, exposure and development processes to form a third encapsulating layer 253 to form an encapsulating layer 25, as shown in FIG. 23.

In act S17, a color filter layer 30 is formed on one side of the encapsulating layer 25 away from the substrate, as shown in FIG. 5.

In an exemplary embodiment, the color filter layer 30 includes a first color filter, a second color filter and a third color filter corresponding to sub-pixels.

In an exemplary embodiment, the first color filter may be a green (G) color filter, the second color filter may be a red (R) color filter, and the third color filter may be a blue (B) color filter. In some possible implementations, a process of preparing the color filter layer 30 includes the blue (B) color filter is first formed, the red (R) color filter is then formed, and the green (G) color filter is then formed. Adhesion of the blue filter is relatively high, and first forming the blue filter first may reduce possibility of stripping the color filter layer 30 from the thin film layer in contact with the color filter layer. Since the red filter has relatively small adhesion but good fluidity, in a process of forming the red filter R, a quantity of bubbles of surfaces of the blue filter and the red filter away from one side of the second electrode may be reduced, so that uniformity of film thickness at an overlapping position of the blue filter and the red filter may be improved. Since a base material of the green filter is approximately the same as that of the red filter, adhesion between the green filter and the red filter is relative large, which may reduce possibility of stripping the color filter layer 30 from the second electrode. In some possible implementations, the color filter layer 30 may include a filter of another color, such as white or yellow.

In act S18, a cover panel 40 is formed by using a sealing process, and the cover panel 40 and the substrate 10 are fixed by sealant (not shown in the figure), as shown in FIG. 6.

An embodiment of the present disclosure also provides an electronic device, including the display panel according to any one of the previous embodiments.

In an exemplary embodiment, the electronic device includes a VR device or an AR device.

The drawings in the present disclosure only refer to the structures involved in the embodiments of the present disclosure, and other structures may refer to common designs.

For the sake of clarity, the thickness and size of layers or microstructures are exaggerated in the drawings used to describe the embodiments of the present disclosure. It will be understood that when an element such as a layer, thin film, region or substrate is referred to as being "on" or "under" another element, the element may be "directly" "on" or "under" the another element, or there may be an intervening element.

Although implementations disclosed in the present disclosure are as the above, the described contents are only implementations used for facilitating understanding the present disclosure, and are not used to limit the present disclosure. Any person skilled in the art to which the present disclosure pertains may make any modifications and variations in the form and details of implementation without departing from the spirit and the scope of the present disclosure, but the patent protection scope of the present disclosure shall still be subject to the scope defined in the appended claims.

## Claims

1. A display panel, comprising a substrate and an array structure layer and a light-emitting structure layer which are sequentially disposed on the substrate, wherein
the substrate comprises a transistor, the array structure layer comprises a first conductive post, a connecting electrode and a second conductive post which are sequentially disposed, the light-emitting structure layer comprises a first electrode, an organic light-emitting layer and a second electrode, the first electrode is located on one side of the organic light-emitting layer close to the substrate, and the second electrode is located on one side of the organic light-emitting layer away from the substrate;
the first electrode comprises a first sub-electrode, a second sub-electrode and a third sub-electrode, wherein the second sub-electrode is located on one side of the first sub-electrode away from the substrate, and the third sub-electrode is located on one side of the first sub-electrode close to the substrate;
reflectivity of the first sub-electrode is greater than threshold reflectivity and greater than reflectivity of the second sub-electrode, wherein the reflectivity of the second sub-electrode is less than reflectivity of the third sub-electrode; and
the first electrode is connected with the connecting electrode through the second conductive post, and the connecting electrode is connected with a drain electrode of the transistor through the first conductive post.

2. The display panel according to claim 1, wherein the second sub-electrode is a transmissive electrode, and an orthographic projection on the substrate covers an orthographic projection of the first sub-electrode on the substrate; and
an orthographic projection of the third sub-electrode on the substrate at least covers the orthographic projection of the first sub-electrode on the substrate, and the orthographic projection of the second sub-electrode on the substrate covers the orthographic projection of the third sub-electrode on the substrate.

3. The display panel according to claim 1, wherein
the display panel further comprises a gate line, a length of the first sub-electrode along a first direction is greater than a length of the second sub-electrode along the first direction, and a length of the first sub-electrode along a second direction is smaller than a length of the second sub-electrode along the second direction;
the length of the second sub-electrode along the second direction is 1.2 times that of the first sub-electrode along the second direction; and
the first direction is perpendicular to the substrate, and the second direction is an extending direction of the gate line.

4. The display panel according to claim 3, wherein a manufacturing material of the first sub-electrode comprises silver; and
the length of the first sub-electrode along the first direction is 400 angstroms to 600 angstroms, and the length of the first sub-electrode along the second direction is 1.5 microns to 2.5 microns.

5. The display panel according to claim 3, wherein a manufacturing material of the second sub-electrode comprises indium tin oxide; and
the length of the second sub-electrode along the first direction is 120 angstroms to 180 angstroms, and the length of the second sub-electrode along the second direction is 1.8 microns to 4 microns.

6. The display panel according to claim 3, wherein a manufacturing material of the third sub-electrode comprises titanium; and
a length of the third sub-electrode along the first direction is 80 angstroms to 120 angstroms, and a length of the third sub-electrode along the second direction is 1.5 microns to 2.5 microns.

7. The display panel according to claim 1, wherein a manufacturing material of the first sub-electrode comprises silver, a manufacturing material of the second sub-electrode comprises indium tin oxide, and a manufacturing material of the third sub-electrode comprises titanium.

8. The display panel according to claim 1, wherein the threshold reflectivity is 80%; and
a work function of the second sub-electrode is greater than 5, and a light transmittance of the second sub-electrode is greater than 99%.

9. The display panel according to claim 1, wherein the display panel further comprises a pixel definition layer, an encapsulating layer and a color filter layer;
the pixel definition layer is located on one side of the array structure layer away from the substrate;
the encapsulating layer is located on one side of the light-emitting structure layer away from the substrate; and
the color filter layer is located on one side of the encapsulating layer away from the substrate;
wherein, the manufacturing material of the pixel definition layer comprises silicon oxide.

10. The display panel according to claim 9, wherein the encapsulating layer comprises a first inorganic encapsulating layer, a second inorganic encapsulating layer and a third organic encapsulating layer;
the first inorganic encapsulating layer is located on one side of the second inorganic encapsulating layer close to the substrate; and
the third organic encapsulating layer is located on one side of the second inorganic encapsulating layer away from the substrate.

11. The display panel according to claim 9 or 10, wherein the display panel further comprises: a cover panel; and
the cover panel is located on one side of the color filter layer away from the substrate.

12. An electronic device, comprising the display panel according to any one of claims 1 to 11.

13. A method for manufacturing a display panel, used to manufacture a display panel according to any one of claims 1 to 11, comprising:
forming an array structure layer on a substrate; wherein the substrate comprises a transistor;
forming a first electrode comprising a first sub-electrode, a second sub-electrode and a third sub-electrode on one side of the array structure layer away from the substrate;
forming an organic light-emitting layer on one side of the first electrode away from the substrate; and
forming a second electrode on one side of the organic light-emitting layer away from the substrate to form a light-emitting structure layer comprising the first electrode, the organic light-emitting layer and the second electrode.

14. The method according to claim 13, forming the first electrode comprising the first sub-electrode, the second sub-electrode and the third sub-electrode on one side of the array structure layer away from the substrate comprises:
sequentially coating an anti-reflection thin film and a photoresist on one side of the array structure layer away from the substrate;
performing exposing and developing processing of the anti-reflection thin film and the photoresist;
sequentially depositing a first metal thin film and a second metal thin film on the anti-reflection thin film and the photoresist after exposing processing;
immersing, the substrate, on which the first metal thin film and the second metal thin film are deposited, in stripping solution to strip the photoresist;
performing developing processing of the substrate stripped of the photoresist to strip the anti-reflection thin film to form a third sub-electrode and a first sub-electrode; and
forming a second sub-electrode on one side of the first sub-electrode away from the substrate.

15. The method according to claim 14, wherein the substrate, on which the first metal thin film and the second metal thin film are deposited, is immersed in the stripping solution for less than 30 minutes.

16. The method according to claim 14, wherein forming the second sub-electrode on one side of the first sub-electrode away from the substrate comprises:
depositing a transparent conductive thin film on one side of the first sub-electrode away from the substrate by using a sputtering process;
coating photoresist on the transparent conductive thin film;
performing exposing and developing processing of the photoresist;
etching the transparent conductive thin film by using a dry etching process; and
stripping the photoresist to form the second sub-electrode; wherein the orthographic projection of the second sub-electrode on the substrate covers the orthographic projection of the first sub-electrode on the substrate.

17. The method according to claim 14, wherein an interval time between a start time of depositing the transparent conductive thin film by using the sputtering process on one side of the first sub-electrode away from the substrate and an end time of immersing the substrate, on which the first metal thin film and the second metal thin film are deposited, in the stripping solution to strip the photoresist, is less than 120 minutes.

18. The method according to claim 13, wherein before forming the organic light-emitting layer on one side of the first electrode away from the substrate, the method further comprises:
depositing a pixel definition thin film on one side of the first electrode away from the substrate;
coating photoresist on the pixel definition thin film;
performing exposing and developing processing of the photoresist;
etching the pixel definition thin film by using a dry etching process; and
stripping the photoresist to form a pixel definition layer.

19. The method according to claim 13, wherein after forming the second electrode on one side of the organic light-emitting layer away from the substrate, the method further comprises:
forming an encapsulating layer on one side of the second electrode away from the substrate;
forming a color filter layer on one side of the encapsulating layer away from the substrate; and
forming a cover panel on one side of the color filter layer away from the substrate.
